Europäisches Patentamt

European Patent Office

Office européen des brevets

(19)

(11) EP 0 801 883 B1

## (12) EUROPÄISCHE PATENTSCHRIFT

(45) Veröffentlichungstag und Bekanntmachung des Hinweises auf die Patenterteilung:
**03.03.1999 Patentblatt 1999/09**

(21) Anmeldenummer: **95905534.4**

(22) Anmeldetag: **05.01.1995**

(51) Int Cl.6: **H05K 3/42**, C25D 21/10

(86) Internationale Anmeldenummer:
**PCT/DE95/00029**

(87) Internationale Veröffentlichungsnummer:
**WO 96/21341 (11.07.1996 Gazette 1996/31)**

(54) **VERFAHREN UND VORRICHTUNG ZUR BEHANDLUNG VON MIT FEINSTEN LÖCHERN VERSEHENEN PLATTENFÖRMIGEN WERKSTÜCKEN**

METHOD AND DEVICE FOR THE TREATMENT OF PLATE-SHAPED WORKPIECES HAVING SMALL HOLES

PROCEDE ET DISPOSITIF DE TRAITEMENT DE PIECES EN FORME DE PLAQUES PRESENTANT DES TROUS EXTREMEMENT FINS

(84) Benannte Vertragsstaaten:
**AT DE FR GB IT NL SE**

(43) Veröffentlichungstag der Anmeldung:
**22.10.1997 Patentblatt 1997/43**

(73) Patentinhaber: **Hübel, Egon**
**90537 Feucht (DE)**

(72) Erfinder: **HENIG, Hans**
**D-90445 Nürnberg (DE)**

(74) Vertreter: **Effert, Bressel und Kollegen**
**Radickestrasse 48**
**12489 Berlin (DE)**

(56) Entgegenhaltungen:
**EP-A- 0 586 770          WO-A-92/01088**
**DE-A- 3 905 100          DE-A- 4 322 378**
**DE-U- 9 011 675          US-A- 4 587 000**

- **PATENT ABSTRACTS OF JAPAN vol. 14, no. 16 (E-872) 12. Januar 1989 & JP,A,01 258 488 (ELNA CO LTD) 16. Oktober 1989**
- **PATENT ABSTRACTS OF JAPAN vol. 14, no. 524 (E-1003) 16. November 1990 & JP,A,02 222 194 (FUJITSU LTD) 4. September 1990**

**Beschreibung**

Die Erfindung betrifft ein Verfahren und eine Vorrichtung zur Oberflächenbehandlung von mit feinsten Löchern versehenen plattenförmigen Werkstükken, insbesondere Leiterplatten, mittels flüssiger oder gasförmiger Behandlungsmittel.

Die Oberflächenbehandlung von plattenförmigen Werkstücken, insbesondere Leiterplatten, kann dann Probleme bereiten, wenn diese Löcher enthalten, die sehr fein sind. Vor allem Löcher, bei denen das Verhältnis von Lochdurchmesser zu Lochlänge sehr klein ist, beispielsweise 1:10 oder darunter, können mit den Behandlungsmitteln nur unter Schwierigkeiten bearbeitet werden, weil diese nur mit besonderen Maßnahmen in die Löcher hineingebracht werden können. Derartige Löcher befinden sich vorzugsweise in Mehrlagenleiterplatten, in denen mehrere elektrische Schaltkreislagen übereinander gestapelt und miteinander verklebt sind. Die Löcher dienen in diesem Fall dazu, eine Vielzahl von Leitungsverbindungen zwischen den Innen- und den Außenlagen sowie gegebenenfalls auch zwischen den Innenlagen untereinander vorzusehen. In den meisten Fällen sind die Leiterbahnenden hierzu als kreisförmige oder rechteckige Ankontaktierungsflächen ausgebildet. Die Löcher greifen durch diese Ankontaktierungsflächen hindurch. Zur elektrischen Kontaktierung der einzelnen Schaltkreise miteinander werden.die Wände der Löcher metallisiert. Die dadurch gebildete, an den Lochwandflächen anliegende Kupferhülse stellt die elektrische Kontaktierung zwischen zwei oder mehreren einander zugeordneten Ankontaktierungsflächen der elektrischen Schaltkreise dar.

Zur Metallisierung sind unterschiedliche Behandlungsschritte erforderlich, wie beispielsweise Reinigen, Konditionieren, Aktivieren, Metallisieren und Trocknen. Beim Bohren der Löcher tritt an den jeweils nur wenige Mikrometer dicken Harzbereichen zwischen den Metallflächen der elektrischen Schaltkreise im Inneren der Leiterplatte beispielsweise Kunststoff aus, der sich als verschmierter Harzfilm auf die Bohrungsmantelflächen der zu kontaktierenden Metallschichten legt. Im Falle der meist verwendeten FR4-Leiterplatten (Laminat mit flammhemmendem Harz und Glasfasermatten als Verstärkung) besteht der Kunststoff aus Epoxidharzen. Wenn derartige Verschmierungen etwa 50% der Wandfläche des Loches überdecken, ist eine Leitungsverbindung an den Ankontaktierungsflächen bereits gefährdet. Erreicht der Verschmierungsgrad auch nur bei einem einzigen Kontaktierungsloch etwa 80%, dann ist die gesamte Platte bereits zu verwerfen. Bei einer Vielzahl von Kontaktierungslöchern für eine größere Mehrlagenleiterplatte und den sehr hohen Herstellungskosten ist es daher offensichtlich, daß diese Verschmierungen zu erheblichen Kosten durch Ausschuß führen können, zumal die Erkennung der Verschmierungen nach dem Bohren nur mit erheblichem Aufwand und auch dann nur bei einzelnen Löchern möglich ist.

Die Schwierigkeiten bei der Entfernung der Harzverschmierungen nehmen zu, da ein wachsender Anteil kleiner und kleinster Löcher (beispielsweise kleiner als 0,4 mm Durchmesser) zu bearbeiten ist. Beispielsweise werden bereits Leiterplatten mit einer Dicke von 7,3 mm und mit Löchern von 0,35 mm Durchmessern gefertigt (Verhältnis des Bohrlochdurchmessers zur Länge etwa 1:21).

Erfahrungsgemäß sind die erreichbaren Strömungsgeschwindigkeiten der Behandlungsmittel in Durchkontaktierungslöchern mit Durchmessern unterhalb von 0,3 mm und mit Längen oberhalb von 4,5 mm nicht mehr ausreichend hoch, so daß ein hinreichender Stoffaustausch an den Wandflächen der Löcher nicht mehr gewährleistet ist. In diesem Fall verhalten sich die Löcher nahezu wie Kapillaren, die im günstigsten Fall von den Behandlungsmitteln noch benetzt werden, eine Durchströmung jedoch nur noch schlecht erreichbar ist. Insbesondere bei rauhen Mantelflächen der Löcher ist eine Benetzung und Durchströmung praktisch unmöglich. Dies ist vor allem dann der Fall, wenn mit flüssigen Behandlungsmitteln gearbeitet wird, die eine höhere Viskosität als beispielsweise Wasser aufweisen.

Um eine Benetzung und Durchströmung derartig feiner Löcher zu ermöglichen, wird daher unter anderem vorgeschlagen, die Werkstücke in einer horizontalen Betriebslage durch die Behandlungsanlage hindurchzuführen. Um dabei eine Zwangsdurchflutung der Löcher zu bewirken, wird ein Strom des flüssigen Behandlungsmittels (Schwall, Sprühstrahl) aus einem Düsensystem gegen die ebenen Oberflächen der Werkstücke gerichtet. Die Werkstücke werden während der Behandlung horizontal angeordnet und in horizontaler Transportrichtung durch die Anlage hindurchgeführt. Die Beförderung von einer Behandlungsstation zur nächsten erfolgt über Rollen oder durch verfahrbare Trägerklemmen, wobei die letzteren die einzelnen Werkstücke am Rand einer oder an den Rändern ihrer beiden gegenüberliegenden Seiten zangenartig umfassen.

Beispielsweise wird in der Druckschrift DE 26 06 984 B2 ein Verfahren zum chemischen Reinigen von Kontaktierungslöchern in Leiterplatten mit Hilfe einer aggressiven, Epoxidharzverschmierungen in der Lochwand lösenden Säure als Reinigungsmedium, offenbart, bei dem die horizontal geführte Leiterplatte nach dem Bohren der Kontaktierungslöcher mit konstanter Geschwindigkeit in einer abgeschlossenen Aktivkammer über eine Schwallstrecke hinwegläuft, die von einem unterhalb der Transportbahn und senkrecht zur Transportrichtung angeordneten Schlitzrohr gebildet wird, aus dem das chemische Reinigungsmedium unter Druck austritt, so daß dabei die Kontaktierungslöcher der Leiterplatte intensiv durchspült werden. Danach wird die Leiterplatte mit einem scharfen Luftstrahl abgeblasen und gespült.

Weiterhin wird auch in der deutschen Patentschrift DE 30 11 061 C2 ein Verfahren zur Intensivierung von Spül- und Reinigungsprozessen für mit Perforationen versehene Formstücke, wie Leiterplatten und Formätzteile, in mit Düsen versehenen Spül- und Reinigungsautomaten, bei denen die Formstücke bei Behandlung in Aktivkammern auf einer Transportbahn durch Spülkammern geführt und von unten mit Spülmittel behandelt werden, offenbart, bei dem in den Spülkammern zusätzlich Spülmittelschwallstrecken verwendet werden und zur Erzeugung der Spülmittelschwallstrecken zumindestens ein unter der Transportbahn angeordnetes Schlitzrohr verwendet wird, aus dem das Spülmittel unter Druck austritt.

In der deutschen Offenlegungsschrift DE 35 28 575 A1 wird ein Verfahren zur Reinigung, Aktivierung und/oder Metallisierung von Bohrlöchern in horizontal geführten Leiterplatten beschrieben, bei dem die Leiterplatten mit konstanter Geschwindigkeit über eine Schwallstrecke hinweglaufen, die von einer unterhalb der Transportbahn und senkrecht zur Transportrichtung angeordneten Düse gebildet wird, aus dem das flüssige Behandlungsmittel in Form einer stehenden Welle an die Unterseite der Leiterplatte gefördert wird.

Gemäß den vorstehenden Druckschriften zum Stand der Technik versteht man unter der Bezeichnung "Schwall" einen kontinuierlich fließenden Strom (Strahl) der verschiedenen Behandlungsmittel, insbesondere der flüssigen, aber auch der gasförmigen Mittel, wobei der Strom aus Schwalldüsen mit möglichst hoher Geschwindigkeit austritt und auf das zu behandelnde plattenförmige Werkstück (Leiterplatte) auftrifft.

Neben diesen Verfahren sind auch solche Verfahren bekannt, bei denen die flüssigen Behandlungsmittel mittels Spritz-oder Sprühvorrichtungen gegen die zu behandelnden Werkstücke verspritzt oder versprüht werden. Beim Spritzen oder Sprühen sind die Behandlungsmittel stark mit Luft durchsetzt.

Durch das Schwallen, Spritzen oder Sprühen der flüssigen Behandlungsmittel gegen das Werkstück werden die in dem Werkstück befindlichen Löcher zwangsweise durchflutet, d.h. es wird eine möglichst große Relativbewegung zwischen den Wandflächen der Löcher und den durch die Löcher hindurchfließenden Behandlungsmitteln erzeugt. Diese Relativbewegung ist bekanntlich die wichtigste Voraussetzung für einen wirksamen Stoffaustausch an der Phasengrenze zwischen Festkörper (Wandfläche des Loches) und Behandlungsmittel.

Die bekannten Verfahren unter Verwendung der Schwalltechnik sind jedoch zur Durchflutung sehr feiner Löcher nicht geeignet. Zur Erläuterung wird auf ein konkretes Beispiel aus der betrieblichen Praxis zurückgegriffen:

Bei einer Leiterplatte mit im Mittel 64 Löchern pro $cm^2$ Oberfläche mit einem Lochdurchmesser von 0,3 mm, beträgt die Summe der Querschnittsflächen der Löcher etwa 4,5 $mm^2$ pro $cm^2$ Leiterplattenoberfläche. Das Verhältnis der mittleren offenen Durchtrittsfläche in der Leiterplatte zum geschlossenen Anteil der Plattenoberfläche beträgt damit etwa 4,5 % .

Der Schwallstrahl trifft mit hoher Geschwindigkeit senkrecht auf die ebene horizontale Oberfläche der Leiterplatte. Da die offene Oberfläche der Leiterplatte im Bereich der Löcher nur einen kleinen Anteil der Gesamtoberfläche ausmacht, spaltet sich der auftreffende Strahl in zwei näherungsweise gleich große, in entgegengesetzte Richtungen auseinanderstrebende, parallel zur Transportrichtung angeordnete Strömungskomponenten. Diese Ströme fließen auf und entlang der Plattenoberfläche. Der geringe Anteil der Querschnittsöffnungen in dem mit Löchern durchsetzten Werkstück gibt einen hinreichenden Hinweis auf den geringen Anteil des Schwallstrahls, der trotz Zwangsdurchflutung durch die Löcher strömt.

Weiterhin behindert das parallel zur Oberfläche fließende Behandlungsmittel die Bildung von Strömungen durch die Löcher, da die hindurchtretenden Strömungen senkrecht zur entlang der Plattenoberfläche strömenden Flüssigkeit gerichtet sind. Der Schwallstrahl übt im Gegensatz zu dessen beabsichtigter Wirkung somit einen hemmenden Effekt auf das Zustandekommen der Durchflutung der Löcher aus.

Auch die in der deutschen Offenlegungsschrift DE 39 16 694 A1 beschriebene Anordnung zur Behandlung und/oder Reinigung von Gut, insbesondere von mit Bohrungen versehenen Leiterplatten, mit Hilfe einer im Schwall herangeführten Flüssigkeit, wobei auf der einen Seite des zu reinigenden oder zu behandelnden Gutes eine Schwallstrecke und auf der anderen Seite des Gutes eine Saugstrecke vorgesehen ist, führt nicht zum gewünschten Erfolg. Zwar wird in diesem Fall die Zwangsdurchflutung durch Mittel zum Absaugen der durch die Löcher hindurchgedrückten flüssigen Behandlungsmittel verbessert. Jedoch kann mit dieser Anordnung lediglich der Widerstand, der dem hindurchtretenden Behandlungsmittel durch gegebenenfalls rauhe Lochwandflächen entgegengesetzt wird, überwunden werden.

Auch das in der deutschen Patentschrift DE 40 17 380 C1 beschriebene Verfahren zur Spülung von Löchern in zu galvanisierenden Gegenständen, insbesondere plattenförmigen und mehrlagigen Gegenständen wie Leiterplatten, beseitigt nicht die Probleme bei der Durchströmung feinster Bohrungen. Bei diesem Verfahren wird die Reinigungs- oder Spülflüssigkeit unter Druck durch die Löcher hindurchgeführt; die Geschwindigkeit des die Bohrungen durchströmenden Flüssigkeitsstromes wird alternierend erhöht oder verringert.

Die in den vorstehend angegebenen Druckschriften beschriebenen Schwalldüsen bestehen aus einem länglichen geradlinigen Gehäuse, welches senkrecht zur Transportebene der horizontal durchlaufenden Leiterplatten sowie parallel zu diesen angeordnet ist und über einen Längsschlitz verfügt, aus welchem der austretende Schwallstrahl senkrecht auf die ebene Oberfläche der plattenförmigen Werkstücke auftrifft.

Aus den vorstehenden Erörterungen ist erkennbar, daß während der Gesamtbehandlungszeit des Werkstückes nur ein Bruchteil der Plattenoberfläche und somit auch nur ein Bruchteil der darin befindlichen Löcher mit dem Behandlungsmittel intensiv bestrahlt wird. Die Behandlung des Werkstückes erfolgt örtlich und zeitlich ungleichmäßig auf der Oberfläche, so daß durch den horizontalen Transport des Werkstückes durch die Anlage hindurch lediglich nach und nach eine Behandlung aller Oberflächenbereiche ermöglicht wird. Dies bringt jedoch mit sich, daß während eines erheblichen Anteils der Gesamtbehandlungszeit des Werkstückes in der Behandlungsanlage keine oder nahezu keine Behandlungsmittelströmung in den Löchern erzeugt wird.

In der deutschen Patentschrift DE 39 05 100 C2 wird ein Verfahren zur chemischen oder elektrolytischen Oberflächenbehandlung von mit kleinen Öffnungen versehenen plattenförmigen Werkstücken, insbesondere von großflächigen, mit Bohrlöchern versehenen Leiterplatten, für gedruckte Schaltungen in wäßrigen Lösungen beschrieben, wobei das Werkstück zwei selbständige, voneinander unabhängige Schwingungsbewegungen ausführt, wobei die erste Schwingungsbewegung rechtwinklig zur Fläche des Werkstückes verläuft und die zweite Schwingungsbewegung in etwa derselben Richtung wie die erste Schwingungsbewegung und gleichzeitig mit dieser erfolgt, wobei die Frequenz der ersten Schwingungsbewegung wesentlich niedriger ist als die der zweiten Schwingungsbewegung, die eine in rascher Folge heftig pulsierende Vibrationsschwingung darstellt und wobei die Amplitude der ersten Schwingungsbewegung wesentlich größer ist als die der zweiten Schwingungsbewegung.

Dieses Verfahren eignet sich ausschließlich für die Behandlung von plattenförmigen Werkstücken in Anlagen mit Bädern, in die die Werkstücke vertikal tauchend eingeführt und nach der Behandlung wieder aus diesen nach oben herausgehoben werden, worauf sich ein Transport der Werkstücke zur nächsten Behandlungsstation anschließt. Nachteilig bei diesem Verfahren ist insbesondere, daß sich die Vibrationsschwingungen, die die Durchströmung der Löcher in den Werkstücken begünstigen sollen, kaum auf alle Werkstücke, die in das Bad getaucht werden, übertragen lassen. Bei Verwendung der üblichen Tauchbäder, die teilweise eine Tiefe von 1,80 m erreichen, könnten die am unteren Ende des Werkstückhalters befestigten Werkstücke nur noch mit unverhältnismäßig hohem Aufwand in Schwingungen mit ausreichender Amplitude versetzt werden. Außerdem können Bohrungen in den Werkstücken kaum durchflutet werden, da keine Flutrohre vorgesehen sind. Wegen der Bewegung der Werkstücke müßten eventuell vorhandene Flutrohre auch einen relativ großen Abstand zu den Werkstücken einhalten. Die Werkstücke könnten nur schwierig von oben in den Badbehälter eingeführt werden, wenn Flutrohre in geringem Abstand von den Werkstücken angeordnet wären. Der vorliegenden Erfindung liegt von daher das Problem zugrunde, die vom Stande der Technik bekannten Nachteile zu vermeiden und ein Verfahren zur Behandlung von plattenförmigen von mit feinsten Löchern versehenen Werkstücken, insbesondere von Leiterplatten, mittels flüssiger oder gasförmiger Behandlungsmittel zu finden.

Das Problem wird gelöst durch die gegenstände der Ansprüche 1 und 12. Bevorzugte Ausführungsformen der Erfindung sind in den Unteransprüchen angegeben.

Durch die erfindungsgemäßen Maßnahmen werden die Wandflächen von Löchern in plattenförmigen Werkstücken, insbesondere von Leiterplatten, mittels flüssiger oder gasförmiger Mittel so behandelt, daß strömungsmechanisch eine möglichst hohe Relativbewegung zwischen den Wandflächen der Löcher und den an diesen entlangströmenden flüssigen oder gasförmigen Behandlungsmitteln erzeugt wird.

Bei der erfindungsgemäßen Lösung werden die in einer horizontalen Betriebslage befindlichen Werkstücke in eine Kombinationsbewegung versetzt, welche sich aus zwei voneinander unabhängigen Bewegungen zusammensetzt. Hierzu wird die Leiterplatte in einer ersten kontinuierlich und/oder periodisch intermittierend gleitenden Bewegung in einer horizontal verlaufenden Transportbahn bewegt und dabei durch eine Behandlungsanlage hindurchgeführt und zugleich in eine zweite, aus heftigen Vibrationsschwingungen bestehende Bewegung versetzt.

Die Frequenz der Vibrationsschwingungen wird hierbei vorzugsweise auf einen Wert oberhalb von 1 Hertz und die Amplitude der Schwingungsbewegung auf einen Wert unter 10 mm eingestellt.

Die Bahnen der Schwingungsbewegungen können entweder linear oder auch kreisförmig oder kreisähnlich sein. Für den Fall kreisförmiger oder kreisähnlicher Schwingungsbewegungen bestehen die beiden Möglichkeiten, daß die Kreisbewegungen im wesentlichen senkrecht zu den Werkstückoberflächen oder im wesentlichen parallel zu diesen verlaufen. Es sind jedoch auch andere Winkel zwischen den Schwingungsebenen und den Werkstückoberflächen möglich.

Die Drehrichtung der kreisförmigen oder kreisähnlichen Schwingungsbewegungen kann auch periodisch wechseln, um eine möglichst gleichmäßige Durchflutung der Löcher zu erreichen.

Die erfindungsgemäßen Vorrichtungen umfassen Mittel zum Erfassen der Werkstücke in horizontaler Betriebslage und zum kontinuierlichen bzw. in periodischen Zeitintervallen intermittierend gleitenden Bewegen in einer horizontal verlaufenden Transportbahn sowie weitere Mittel zum Versetzen der Werkstücke in heftig pulsierende Vibrationsschwingungsbewegungen. Ferner sind auch Mittel zum In-Kontakt-Bringen der Werkstücke mit den Behandlungsmitteln vorgesehen.

Zur Erzeugung kreisförmiger oder kreisähnlicher Vibrationsschwingungsbewegungen wird vorzugsweise ein Unwuchtvibrator eingesetzt.

Für die Intensivierung der Durchströmung der Löcher und zur Verbesserung der Oberflächenbehandlung der Werkstücke können ferner Ultraschallschwinger zur Erzeugung von im wesentlichen senkrecht auf die Werkstückoberflächen auftreffenden Ultraschallwellen im Behandlungsmittel eingesetzt werden. Dadurch wird eine verstärkte turbulente Strömung innerhalb der Löcher erzeugt. Ultraschall wird üblicherweise lediglich beim Reinigen der Lochmantelflächen eingesetzt.

Die Ultraschallwellen haben Frequenzen oberhalb von etwa 10 Kilohertz. Die Schallwellen werden im wesentlichen senkrecht auf die Leiterplattenoberflächen abgestrahlt, wobei vorzugsweise keine Abschirmungen zwischen den Ultraschallschwingern und den Oberflächen angeordnet sind. Obwohl die Lochwandflächen parallel zur Ausbreitungsgeschwindigkeit der Schallwellen liegen, wirken die Schallwellen auch an diesen, da die gesamten Werkstücke durch die Beschallung in mechanische Schwingungen versetzt werden und so die Strömungsverhältnisse an den Lochwandflächen günstig beeinflussen.

Die Wirkung des erfindungsgemäßen Verfahrens ist dann besonders groß, wenn beide Werkstückoberflächen mit dem Behandlungsmittel benetzt sind und vorzugsweise dann, wenn das Werkstück zur Behandlung vollständig in das Behandlungsmittel eingetaucht wird.

Jedoch werden auch dann gute Behandlungsergebnisse erreicht, wenn nur eine der Oberflächen von dem Behandlungsmittel benetzt wird, beispielsweise durch Beschwallen, Besprühen oder Bespritzen der oberen oder unteren Seite des horizontal liegenden Werkstücks.

Während der Bewegung der Werkstücke können auch im wesentlichen kontinuierliche Ströme oder Sprüh- bzw. Spritzstrahlen des Behandlungsmittels aus hierfür geeigneten Vorrichtungen gegen deren Oberflächen gerichtet werden. Dadurch werden die Vorteile des erfindungsgemäßen Verfahrens mit denen der nach dem Stand der Technik bekannten Verfahren, bei denen die Löcher in den Werkstücken mittels aus Schwalldüsen austretenden Behandlungsmitteln durchströmt werden, kombiniert.

Diese Verfahrensweise kann weiter verbessert werden, wenn das Behandlungsmittel aufgrund eines Unterdruckes an eine der Werkstückoberflächen durch die Löcher hindurchgesaugt wird. Als geeignete Vorrichtungen zum Erzeugen des Unterdruckes haben sich einer Werkstückoberfläche gegenüberliegende Saugkammern mit vorzugsweise rechteckigen Öffnungen eines prismatischen Schachtes herausgestellt.

Für die meisten Verfahren kommen flüssige Behandlungsmittel in Betracht, diese weisen jedoch eine höhere Viskosität als gasförmige Behandlungsmittel auf. Eine Durchströmung der Löcher mit den flüssigen Behandlungsmitteln ist also schwieriger.

Das erfindungsgemäße Verfahren schließt auch die Behandlung der Werkstücke mit gasförmigen Behandlungsmitteln ein, insbesondere zum Trocknen der Löcher in Leiterplatten mittels erwärmter Luft. Bei Anwendung flüssiger Behandlungsmittel können Flüssigkeitsreste von den Oberflächen der Leiterplatten und Mantelflächen der Löcher durch Anströmen mit erwärmter Luft verdunstet werden. Um jedoch die Bildung von Trocknungsflecken zu vermeiden, ist die Anwendung des erfindungsgemäßen Verfahrens beim Trocknen besonders vorteilhaft, weil die Flüssigkeitsreste durch die Vibrationsschwingungsbewegungen als Aerosole von den Oberflächen abgesprengt und durch den Luftstrom von diesen abtransportiert werden.

Gemäß der für laminare Strömungen durch Rohre anwendbaren Hagen-Poiseuille-Gleichung nimmt die dynamische Viskosität der insbesondere flüssigen Behandlungsmittel mit steigender Temperatur des Behandlungsmittels ab. Der Stoffaustausch innerhalb der Löcher wird also verbessert, wenn die Behandlungsmittel bei möglichst hoher Temperatur eingesetzt werden. Durch die Temperaturerhöhung wird das Durchflußvermögen des Behandlungsmittels durch die Löcher und dadurch die Entstehung turbulenter Strömungen in den Löchern und die Diffusion innerhalb des Behandlungsmittels verbessert. Die obere Temperaturgrenze hängt andererseits jedoch von der für den Behandlungsschritt spezifischen, maximal zulässigen Temperatur ab.

In den meisten Fällen der nach dem Stand der Technik bekannten Verfahren und Vorrichtungen wird vorgeschlagen, die Behandlungsmittel gegenüber den praktisch stationären Lochwandflächen zu bewegen. Nach der vorliegenden Erfindung wird im Gegensatz dazu die Lösungsalternative verfolgt, auch die Leiterplatte und damit die Wandflächen in den Löchern gegenüber dem Behandlungsmittel zu bewegen.

Beide Varianten können jedoch auch kombiniert werden. Versuchsreihen in betrieblichem Maßstab mit den erfindungsgemäßen Vorrichtungen haben allerdings gezeigt, daß es für einen ausreichend wirksamen Stoffaustausch an den Lochwandflächen beim Einsatz des erfindungsgemäßen Verfahrens einer Zwangsdurchflutung der Löcher mittels eines Schwallstrahles nicht bei jeder Anwendung bedarf.

Gemäß der Erfindung wird das Werkstück in heftige Vibrationsschwingungen versetzt. Die mit hoher Frequenz erfolgenden Richtungsänderungen erzeugen in den Löchern instabile Strömungsverhältnisse, insbesondere wegen der bekanntermaßen unterschiedlichen Geschwindigkeiten der einzelnen Schichten eines das Loch durchflutenden Strahles des Behandlungsmittels, so daß örtlich turbulente Strömungen mit einer stark wirbelnden Durchmischung der einzelnen Behandlungsmittelschichten untereinander entstehen. Die Schichten turbulenter Strömung mit räumlich sehr kleinen Wirbelfeldern haben eine hülsenartige Form. Die Schichten sind entsprechend dem Geschwindigkeitsprofil derartiger Strahlen konzentrisch im Loch angeordnet. Die Dikke der durch die Vibrationsschwingungsbewegungen entstehenden turbulent bewegten Schichten beträgt größenordnungsmäßig etwa 500 µm.

Der für die Oberflächenbehandlung erforderliche Stoffaustausch (Transport frischer Behandlungsmittel an die Lochwandoberflächen sowie Abtransport von Reaktionsprodukten von dort) findet in einer unmittelbar an der Lochwandoberfläche anliegenden verhältnismäßig dünnen Grenzschicht statt, die an dieser durch molekulare Adhäsionskräfte haftet und sich daher mit der Lochwandoberfläche und damit mit dem gesamten Werkstück bewegt. Innerhalb dieser Schicht erfolgt der Stofftransport ausschließlich durch Diffusion.

Die sich an die Lochwandfläche zum Lochinneren hin anschließenden Schichten des Behandlungsmittelstrahles werden mit dem vibrierenden Werkstück ebenfalls in Bewegung versetzt, jedoch werden die dem Behandlungsmittel durch das vibrierende Werkstück erteilten Bewegungen mit wachsendem Abstand von der Lochwandoberfläche kleiner. Durch die innere Reibung im Behandlungsmittel entsteht innerhalb der Grenzschicht von der Mitte des Loches hin zur Lochwand ein Geschwindigkeitsgefälle. Der Grad des Geschwindigkeitsgefälles hängt insbesondere von der Viskosität des Behandlungsmittels ab: Bei gasförmigen Behandlungsmitteln ist das Geschwindigkeitsgefälle steiler als bei flüssigen Behandlungsmitteln.

In den Figuren 1 - 4 ist das Prinzip des erfindungsgemäßen Verfahrens, in den Figuren 5 - 9 die erfindungsgemäße Vorrichtung beispielhaft schematisch dargestellt. Es zeigen:

Fig. 1:   die Wirkung einer linearen Schwingung;
Fig. 2:   die Wirkung einer kreisförmigen senkrecht zur Plattenebene stehenden Vibrationsschwingungsbewegung;
Fig. 3:   die Darstellung der Geschwindigkeitskomponenten des Behandlungsmittels im Loch;
Fig. 4 :   eine schematische Darstellung der Strömungsverhältnisse im Loch einer Leiterplatte.

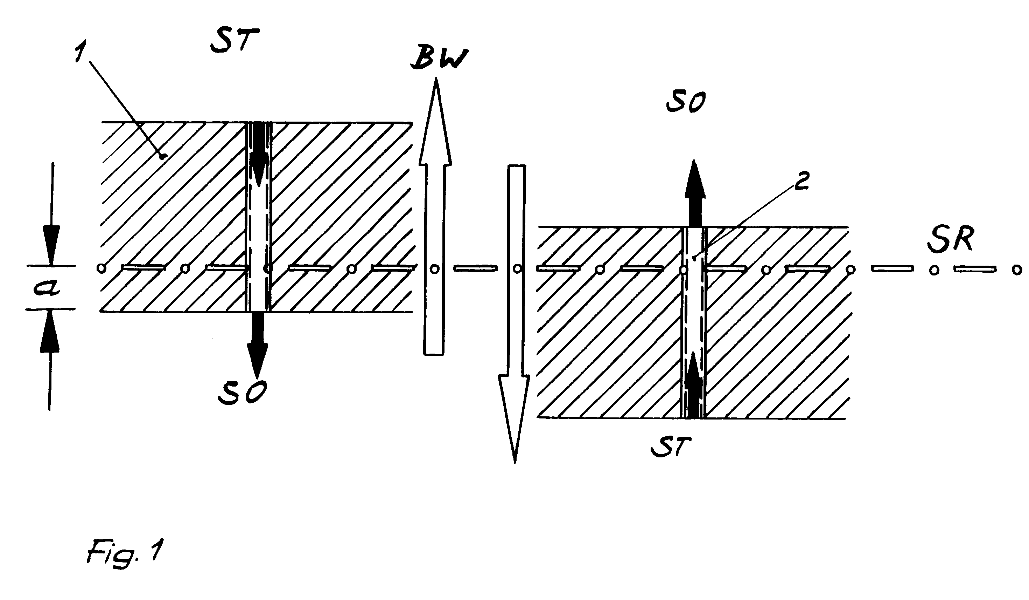

Figur 1 zeigt einen schematischen Querschnitt durch eine Leiterplatte 1 mit einem Loch 2, die eine Vibrationsschwingungsbewegung mit linearen Bewegungsbahnen um die statische Ruhelage SR herum ausführt. Die Bewegungsbahn (Pfeile BW) steht senkrecht auf der Leiterplattenoberfläche.

Wie in der Figur dargestellt, wird eine Pumpwirkung parallel zur Lochachse durch lineare Vibrationsschwingungsbewegungen auf das sich in den Löchern befindende Behandlungsmittel ausgeübt, sofern die Bewegungsbahnen der Vibrationsschwingungen nicht in der Ebene des Werkstückes verlaufen. Das Maß gibt die momentane Auslenkung der Leiterplatte von der statischen Ruhelage SR an.

Das rhythmische Hin- und Herbewegen der Werkstücke 1,3 mit Loch 2 zwischen den beiden Wendepunkten der Schwingungsbahnen hat in gleicher Richtung wirkende Kraftkomponenten des Behandlungsmittels am Locheintritt und -austritt zur Folge (in der Figur mit Pfeilen angedeutet). Bewegt sich das Werkstück während der Vibrationsschwingungsbewegungen in die eine Richtung, dann entsteht am Lochende in der Bewegungsrichtung ein hydrodynamisches Staugebiet (Überdruck ST) und am anderen Ende ein Soggebiet (Unterdruck SO). Die sich daraus ergebenden Druckdifferenzen wirken wie eine Antriebskraft auf die Flüssigkeitssäule und pumpen diese im Loch in die der Werkstückbewegung entgegengesetzte Richtung. Kehrt die Schwingungsrichtung des Werkstückes um, so ändert sich auch die Richtung der Pumpwirkung um 180°.

Die Schwingungsbewegungen können einer Sinuskurve folgen. Jedoch können auch andere Schwingungsformen vorteilhaft sein. Das Entstehen und der Verlauf der Behandlungsmittelströmungen in den Bohrungen wird durch sanft ansteigende oder abnehmende Geschwindigkeiten vorzugsweise im Mittelbereich des Loches laminar. Die laminare Strömung in der Mitte des Loches wird von einem Mantel turbulenter Wirbelfelder umgeben. Diese bilden den Übergang zu den an den Lochmantelflächen anhaftenden stationären Grenzschichten. Innerhalb der Grenzschichten werden Stoffe ausschließlich durch Diffusion transportiert. Die Geschwindigkeit des Transportes hängt dabei von der Grenzschichtdicke ab; dickere Schichten behindern die Diffusion. Durch Vibrationsschwingungsbewegungen wird die Dicke der Grenzschichten deutlich reduziert. In diesem Falle können Stoffe im Behandlungsmittel auch schneller an die Lochwandoberflächen gelangen.

Ein wirksamer Stoffaustausch setzt jedoch voraus, daß die hierzu benötigten Stoffe im sich außerhalb des Loches befindenden Behandlungsmittel in das Lochinnere, dort durch Vermischung schnell in die Bereiche mit turbulenter Strömung und von dort schließlich durch die Grenzschicht an die Lochwandoberflächen befördert werden. Im umgekehrten Falle, beispielsweise wenn die Lochwandoberflächen gereinigt und Verunreinigungen von diesen abtransportiert werden müssen, findet der Stofftransport in umgekehrter Richtung statt. Auch in diesem Fall sind die in den Löchern erzeugten Strömungsbedingungen für die gestellten Anforderungen geschwindigkeitsbestimmend.

In Versuchen konnte gezeigt werden, daß auch dann, wenn es mit bekannten Methoden nicht gelang, feinste Löcher mit Behandlungsmitteln zu durchströmen, beispielsweise wegen eines zu hohen Verhältnisses des Durchmessers der Löcher zu deren Länge, eine Erzeugung der lokalen Wirbelfelder eine intensive Durchmischung der Behandlungsmittel innerhalb der Löcher sowie in den Gebieten in der Nähe der Lochwandoberflächen bewirkt und auf diese Weise ein hinreichender Stoffaustausch an diesen ermöglicht wird.

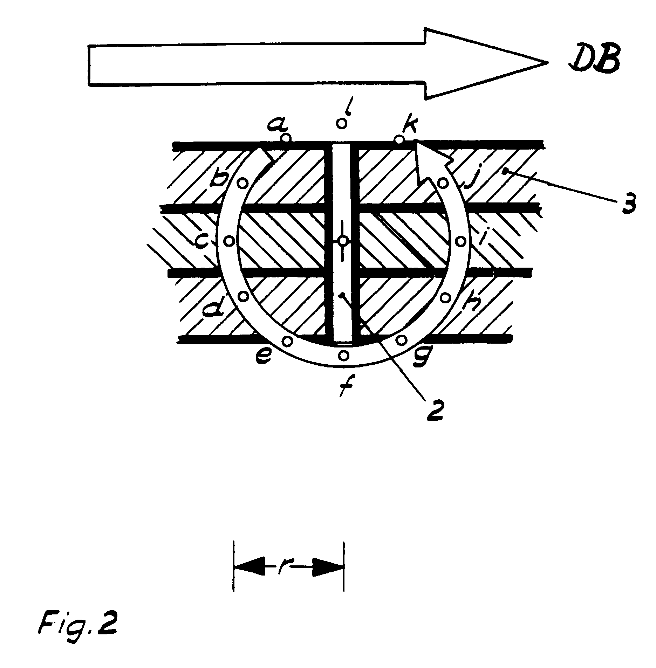

In Figur 2 ist eine weitere bevorzugte Ausführungsform des erfindungsgemäßen Verfahrens schematisch dargestellt. Anstelle einer linearen Vibrationsschwingungsbewegung können die Werkstücke auch in kreisförmige oder kreisähnliche Vibrationsschwingungsbewegungen versetzt werden, wobei die Bewegungen entweder, wie in der Figur gezeigt, in einer Ebene verlaufen, die senkrecht auf der Werkstückoberfläche steht oder in einer Ebene, die parallel zu dieser angeordnet ist.

In der Figur ist der Bewegungsverlauf des Mittelpunktes des Loches in verschiedenen Stadien a - 1 einer vollen Rotationsschwingung dargestellt. Diese Schwingungsbewegung kann sowohl im Uhrzeiger- als auch im Gegenuhrzeigersinn ausgeführt werden und dabei auch seine Richtung ändern, wobei die Durchlaufbewegung DB der Leiterplatte beibehalten wird.

Mit der Bezugsziffer 3 ist die schematisch im Querschnitt dargestellte Leiterplatte, mit der Bezugsziffer 2 das durch die Leiterplatte hindurchführende Loch bezeichnet. Die Abmessung r kennzeichnet die Amplitude der Kreisschwingung.

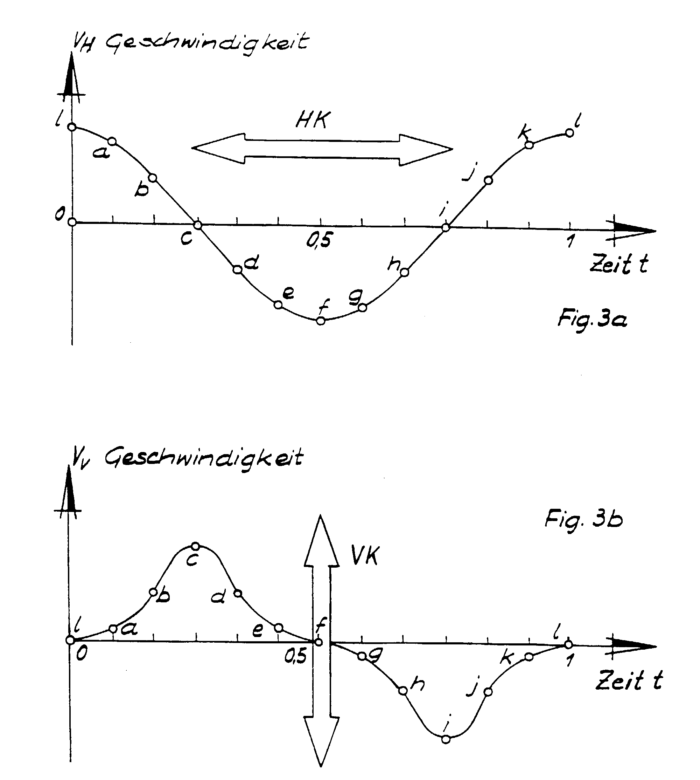

Die auf die schematische Darstellung in der Figur 2 bezogenen Figuren 3a und 3b geben in einem Graphen die Geschwindigkeitskomponenten während eines vollen Umlaufes bei der Schwingungsbewegung wieder. Die Bezugspunkte a - 1 in den Figuren 2, 3a und 3b kennzeichnen die Orte, die der Referenzpunkt während des Umlaufes passiert.

Der horizontale Doppelpfeil HK in Figur 3a soll den rhythmisch zu- und abnehmenden Anpreßdruck, der durch die jeweilige Geschwindigkeitskomponente $V_H$, aufgetragen über die Zeit t, quer zur Lochachse beim Umlauf entsteht und zu dieser proportional ist, veranschaulichen. Dieser Anpreßdruck wirkt in Richtung auf die Lochwandoberflächen. Durch diese sich zeitlich verändernde Geschwindigkeitskomponente und damit durch den sich zeitlich verändernden Anpreßdruck ergibt sich auch ein gesteigerter Stoffaustausch an den Lochwandoberflächen durch Veringerung der Grenzschichtdicke als auch eine Erhöhung der Turbulenz in der sich an die Grenzschicht anschließenden turbulenten Behandlungsmittelschichten im Loch.

Der vertikale Doppelpfeil VK in Figur 3b veranschaulicht das pulsierende Hindurchpumpen der Behandlungslösung durch das Loch entlang ihrer Achse, wobei die sich pro Zeiteinheit t zeitlich verändernde vertikale Geschwindigkeitskomponente $V_V$ in axialer Richtung ebenfalls proportional zu der bereits zuvor beschriebenen Pumpwirkung ist. Durch die Vibrationsschwingungsbewegung wird die Durchflußrate in der laminaren Zone des Loches erhöht.

Ebenso wie bei linearen Vibrationsschwingungsbewegungen werden im Falle der kreisförmigen oder kreisähnlichen Vibrationsschwingungsbewegungen Frequenzen oberhalb von 1 Hertz und Kreisamplituden r auf einen Wert unterhalb von 10 mm eingestellt. Gemäß einer weiteren bevorzugten Ausführungsform ist die Ebene der kreisförmigen oder kreisähnlichen Vibrationsschwingungsbewegungen parallel zu den Werkstückoberflächen angeordnet. In diesem Fall ergibt sich eine zentrifugale Schleuderkraft des sich innerhalb des heftig kreisenden Loches befindenden Behandlungsmittels, wobei diese Schleuderkraft an den Volumenelementen des Behandlungsmittels im Loch angreift und diese ebenfalls an die Lochwände drückt. Wird die Drehrichtung der in der Ebene der Werkstückoberfläche liegenden kreisförmigen oder kreisähnlichen Vibrationsschwingungsbewegung periodisch gewechselt, so ist es möglich, den Stoffaustausch innerhalb des Loches weiter zu erhöhen.

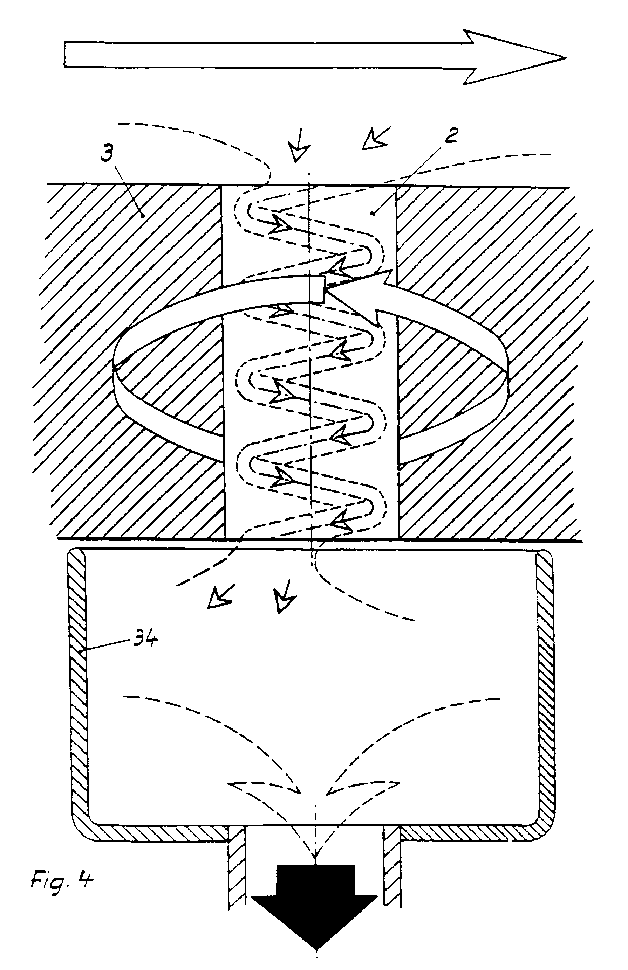

In Fig. 4 sind die Strömungsverhältnisse in einem Loch des Werkstückes bei Anwendung kreisförmiger oder kreisähnlicher Vibrationsschwingungsbewegungen (elliptischer Pfeil) in der Ebene der Werkstückoberfläche und gleichzeitig einer gleitenden Vorwärtsbewegung des Werkstückes (oberer langer Pfeil) schematisch dargestellt, wobei das Behandlungsmittel von oben her kommend nach unten durch das Loch hindurchgesaugt wird.

Das in das Loch hineingezogene Behandlungsmittel wird durch die Vibrationsschwingungsbewegungen auf eine spiralförmige Bahn gezwungen. Dadurch wird eine turbulente Durchmischung der einzelnen Volumenelemente des Behandlungsmittels im Loch erreicht. Die Dicke der an den Lochwandoberflächen anhaftenden stationären Grenzschicht wird verringert, so daß die Diffusion der Stoffe von und zu diesen verstärkt wird.

Durch die turbulente Verwirbelung wird ein praktisch ungehinderter Durchtritt des Behandlungsmittels durch das Loch ermöglicht.

Anhand eines Beispieles wird die Wirkungsweise des Verfahrens dargestellt:

Das Bohrloch hat einen Durchmesser von 0,3 mm. Das Werkstück, eine Leiterplatte, wird in eine kreisförmige Vibrationsschwingungsbewegung mit einer Frequenz von f = 24 Hertz und einer Amplitude von 0,3 mm versetzt. Dabei erreichen die Lochwandflächen eine Geschwindigkeit von

$$v = f \times 2 \cdot \pi \cdot r = 22{,}6 \text{ mm/sec.}$$

Der Stoffaustausch durch Diffusion findet in der mit der gleichen Geschwindigkeit rotierenden Grenzschicht, die an den Lochwandoberflächen anliegt, statt. Die der Grenzschicht benachbarten Behandlungsmittelschichten werden ebenfalls in rotierende Bewegung versetzt, jedoch mit einer geringeren Geschwindigkeit. Dadurch entsteht ein Geschwindigkeitsgefälle im Loch.

Zum Vergleich wird die Durchströmungsgeschwindigkeit des auf die Oberflächen der Leiterplatte aufgeschwallten flüssigen Behandlungsmittels ohne Vibrationsschwingungsbewegungen der Leiterplatten berechnet:

Wird unterhalb der Leiterplatte gemäß den nach dem Stand der Technik bekannten Vorrichtungen eine Schwalldüse angeordnet, aus der das flüssige Behandlungsmittel beispielsweise mit einem hydrostatischen Druck von 250 Pa entweicht, ergibt sich aus der Hagen-Poiseuille-Gleichung, daß das Behandlungsmittel eine Durchströmungszeit durch das Loch von 4,8 sec benötigt, wenn der Lochdurchmesser 0,3 mm und die Lochlänge 5 mm betragen und das flüssige Behandlungsmittel eine Viskosität wie Wasser aufweist. Daraus kann eine mittlere Geschwindigkeit des Behandlungsmittels im Loch von etwa 1 mm/sec errechnet werden. Dieser Wert liegt deutlich unterhalb des zuvor berechneten Wertes von etwa 22 mm/sec.

Da in den vorstehenden Berechnungen nicht berücksichigt wurde, daß die Lochwandoberflächen im allgemeinen nicht glatt sondern rauh sind, so daß nur ein für die Durchströmung des Loches freier Querschnitt von weniger als $(0,3 \text{ mm})^2$ zur Verfügung steht, dürfte der Wert bei der Behandlung ohne Vibrationsschwingungsbewegungen noch geringer sein.

Die Geschwindigkeit der Durchströmung des Loches ist ein Maß für den Stofftransport bei der Behandlung der Lochwandoberflächen. Daraus ergibt sich zweifelsfrei, daß eine Behandlung von Werkstücken ohne Vibrationsschwingungsbewegungen nicht ausreichend ist, um eine wirksame Behandlung auch feinster Löcher zu gewährleisten. Im Gegensatz dazu kann mit dem erfindungsgemäßen Verfahren mit Vibrationsschwingungsbewegungen eine ausreichend hohe Strömungsgeschwindigkeit in den Löchern erreicht werden, wobei insbesondere die Dicke der durch rauhe Lochmanteloberflächen gebildeten äußerst dicken Grenzschicht, in der der Stofftransport nur sehr langsam vonstatten geht, durch die erzwungenen turbulenten Strömungen verringert wird.

Daraus ergibt sich, daß ein sehr guter Stoffaustausch nicht nur in radialer Richtung im Loch, sondern auch ein verbesserter Austausch in axialer Richtung ermöglicht wird.

Während die Werkstücke in Vibrationsschwingungbewegungen versetzt werden, werden sie kontinuierlich und/oder periodisch intermittierend gleitend in einer horizontal verlaufenden Transportbahn und in horizontaler Betriebslage bewegt und dabei durch die Behandlungsanlage hindurchgeführt. Diese Kombination hat den Vorteil, daß die Werkstücke zum einen in apparativ einfacher Weise erfaßt werden können, so daß die Übertragung der Vibrationsschwingungsbewegungen auf die Leiterplatte ohne wesentliche Verluste ebenfalls einfach erfolgt. Nachteile, wie sie sich beispielsweise aus der vertikalen Anordnung von Leiterplatten bei herkömmlichen Tauchanlagen ergeben, bei denen die am unteren Ende des Warenträgers hängenden Leiterplatten durch die Erregung der Vibrationsschwingungen kaum noch in Bewegung gesetzt werden können, stellen sich bei dem erfindungsgemäßen Verfahren nicht ein. Weiterhin besteht bei der Kombination der Bewegungen die Möglichkeit, die Werkstücke langsam über Einrichtungen hinweg oder unter Einrichtungen hindurchzuführen, aus denen die Behandlungsmittel in einem scharfen Strahl oder Schwall austreten, hierbei durch die Löcher gedrückt werden und dadurch die die Durchströmung der Löcher erzwingende Vibrationsschwingungsbewegungen unterstützen.

Desweiteren können in einfacher Weise auch Saugeinrichtungen vorgesehen werden, die die Durchströmung ebenfalls fördern. Weitere Vorteile derartiger Anlagen, durch die die Werkstücke gleitend hindurchgeführt werden, bestehen darin, daß nur geringe Behandlungsmittelmengen eingesetzt werden müssen, so daß der Aufwand zur Entsorgung verbrauchter Behandlungsmittel geringer ist als in herkömmlichen Tauchanlagen, die Anlagen in apparativ einfacher Weise gekapselt werden können, so daß eventuelle Emissionen von Aerosolen und Gasen vermieden werden und schließlich eine einfache Verkettung der einzelnen Behandlungsmodule möglich ist.

In den nachfolgenden Figuren 5 - 9 werden bevorzugte Ausführungsformen der erfindungsgemäßen Vorrichtung dargestellt.

Es zeigen

Figur 5:       das Funktionsprinzip eines Unwuchtvibrators;

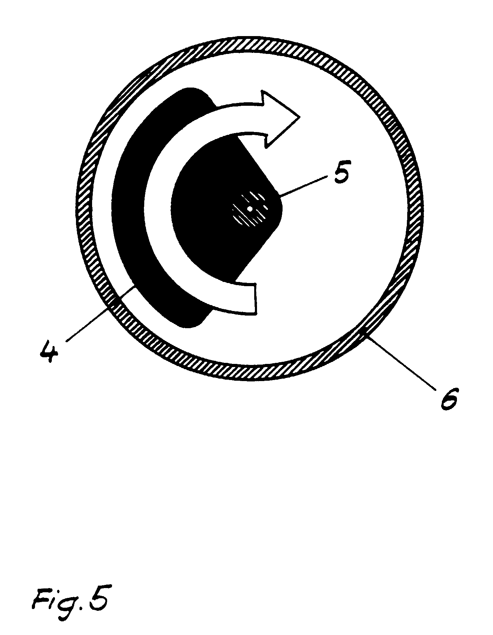

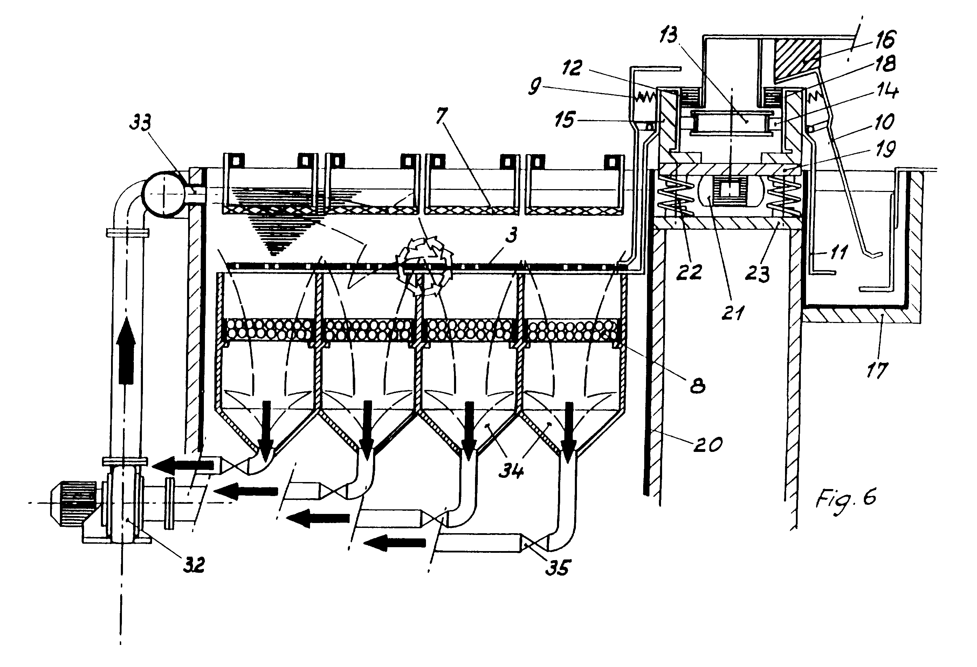

Figur 6:       einen Querschnitt durch eine Metallisierungsanlage für Leiterplatten;

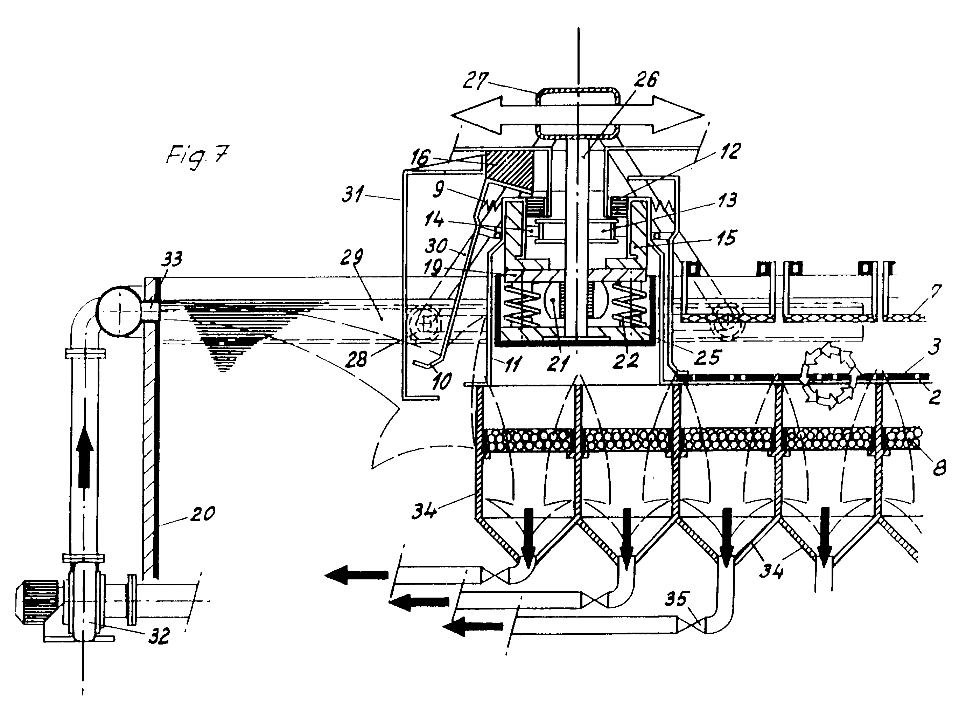

Figur 7:       einen Querschnitt durch eine Metallisierungsanlage mit verfahrbarer Schwingungsanordnung.

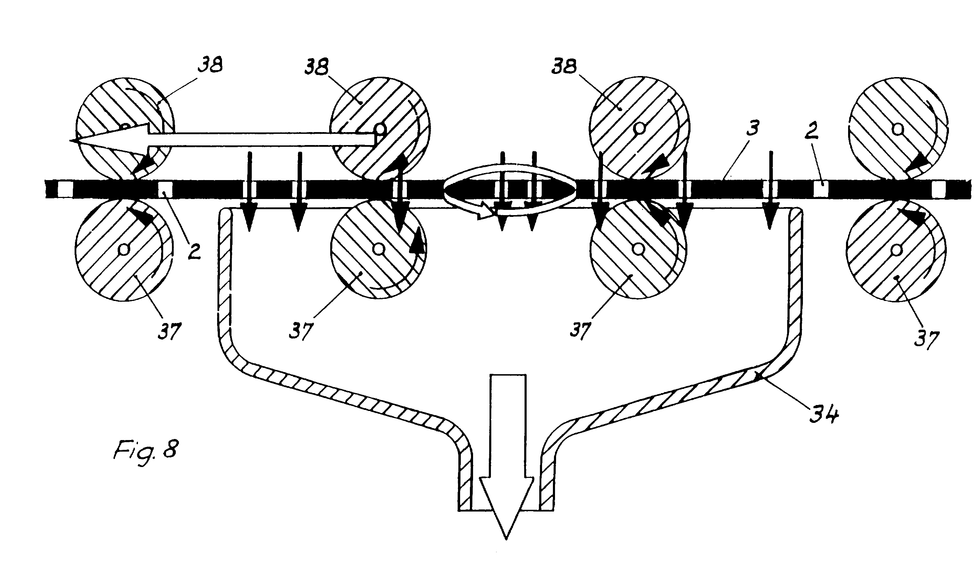

Figur 8:       einen Ausschnitt aus einer Anlage zur chemischen Behandlung von Leiterplatten.

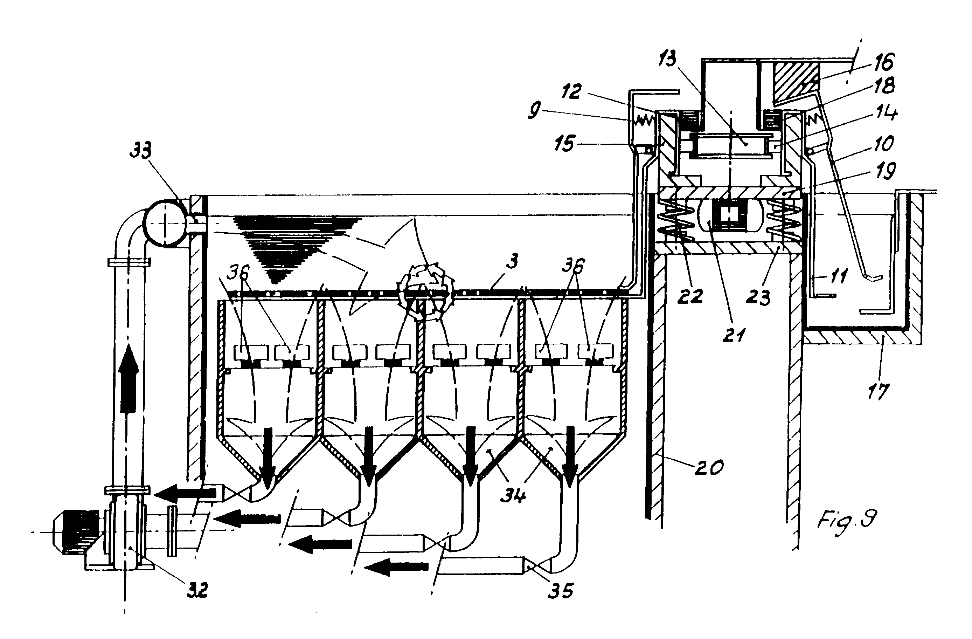

Figur 9:       einen Querschnitt durch eine Metallisierungsanlage mit Ultraschallquellen.

In Figur 4 ist das Funktionsprinzip eines Unwuchtvibrators wiedergegeben, mit dem die erfindungsgemäßen kreisförmigen oder kreisähnlichen Vibrationsschwingungsbewegungen erzeugt werden können.

In dem Vibrator ist ein Rotor 4 auf die Welle 5 eines Elektromotors 6 aufgesetzt. Die durch den exzentrischen Rotor erzeugten Unwuchtkräfte werden mechanisch direkt oder indirekt als Vibrationsschwingungen auf die Leiterplatten 1,3 übertragen. Die Leiterplatten bewegen sich in kreisförmigen ebenen Bahnen mit konstanter Winkelgeschwindigkeit. Die Amplitude der Vibrationsschwingungen kann stufenlos geregelt werden, indem die Unwuchtkräfte eingestellt werden. Üblicherweise werden Schwingungsfrequenzen in der Größenordnung von 24 Hertz angewendet. Dadurch werden Behandlungen mit flüssigen Behandlungsmitteln zur Reinigung, Aktivierung und Metallisierung der Lochwandoberflächen in Leiterplatten auch bei Verhältnissen des Lochdurchmessers zu dessen Länge oberhalb von 1:15 sicher durchgeführt.

In Figur 6 ist ein Querschnitt durch eine Anlage zur elektrolytischen Metallisierung, beispielsweise mit Kupfer, von Leiterplatten dargestellt.

Die in dem flüssigen Behandlungsmittel (Metallisierungslösung) befindlichen oberen Anoden 7 sind parallel zu den darunterliegenden Leiterplatten 3 angeordnet, die entlang einer senkrecht zur Zeichenebene stehenden horizontal verlaufenden Transportbahn geführt werden. Für die Anoden werden vorzugsweise unlösliche Materialien, beispielsweise aus platiniertem Titan, verwendet. Es können jedoch auch die üblichen, aus dem abzuscheidenden Metall bestehenden Anoden eingesetzt werden. Durch die parallele Anordnung werden gleichmäßig verteilte metallische Niederschläge auf den Leiterplatten erzeugt. Die Anoden können in einfacher Weise aus der Anlage herausgenommen werden, so daß dadurch der Zugang zu den unteren löslichen, in perforierten Titankästen enthaltenen, Metallanoden in Kugelform (beispielsweise aus Kupfer) ermöglicht wird.

Die Leiterplatten werden mittels Klammern erfaßt und in einer horizontalen Betriebslage kontinuierlich gleitend durch die Metallisierungsanlage befördert. Die Klammern bestehen aus zwei durch Federdruck 9 zueinander gepreßten Bügeln 10 und 11. Diese Bügel erfassen die Leiterplatten an mindestens einer ihrer rechteckigen Seiten. Sie erfüllen neben der mechanischen Halterung auch die Aufgabe, den elektrischen Strom für die elektrolytische Metallabscheidung auf die Leiterplatte zu übertragen. Hierzu gleitet und schleift der untere Bügel 11 entlang einer Bürstenvorrichtung 12, die an eine nicht dargestellte Stromquelle angeschlossen ist.

Eine größere Anzahl von Klammern sind hintereinander und im Abstand zueinander an einem endlos umlaufenden durch Rollen 13 geführten Band 14 angebracht. Eine Führungsschiene 15 läuft vollständig um das Transportsystem herum, während eine Anlaufschiene 16 sich nur über jenen Bereich der Anlage erstreckt, an welchem kein Transportbedarf für die Leiterplatten besteht. Die Anlauffläche der Schiene 16 ist so positioniert, daß sie unter Zusammendrücken der Feder 9 die Leiterplatten aus dem Bügelpaar ausklinkt.

Um das an den Bügelenden niedergeschlagene Metall nach dem Durchlauf durch die Metallisierungskammer wieder zu entfernen, ist ein weiterer Badbehälter (Entmetallisierungskammer) 17 vorgesehen, der mit der Metallisierungslösung in der Metallisierungskammer in Verbindung steht. Auch in diesem Badbehälter befindet sich die Metallisierungslösung. In der Entmetallisierungskammer ist weiterhin eine Gegenelektrode angeordnet.

Sobald sich das Bügelpaar nach dem Durchlauf durch die Metallisierungskammer in der Kammer 17 befindet, wird ihm über eine elektrisch getrennte Bürstenvorrichtung 18 ein Strom mit einer Polarität zugeführt, die der entgegengesetzt ist, die das Bürstenpaar beim Durchlauf durch die Metallisierungskammer erhält. Dadurch wird das auf den Bügelpaaren niedergeschlagene Metall beim Durchgang durch die Kammer 17 auf elektrolytischem Wege wieder entfernt.

Die Führungsrollen 13 und -schienen 15, das endlose Band 14, die Anlaufschiene 16, die Bürstenvorrichtungen 12 und 18 sind gemeinsam mit der Vielzahl der Bügelpaare 10,11 auf einer Grundplatte 19 als funktionelle Aggregateinheit mechanisch fest in sich zusammengefaßt. Dieses Aggregat ist starr auf der die Behandlungslösung enthaltenden Wanne 20 aufgesetzt.

Unterhalb der Grundplatte 19 ist ein Unwuchtvibrator 21 an dieser befestigt. Dessen kreisförmige Vibrationsschwingungsbewegungen werden resonanzfrei an die zuvor beschriebene Einheit übertragen. Dadurch schwingen der Unwuchtvibrator und das Aggregat gemeinsam mit gleicher Frequenz. Das Aggregat ruht auf einer Anzahl von Schwingungsdämpfern, hier in Form von Spiralfedern 22, die auf einem sich entlang der Wannenreihe 20 erstreckenden massiven Sockel 23 aufgesetzt sind. Diese Schwingungsdämpfer haben die Aufgabe, die von dem Aggregat ausgehenden Vibrationsschwingungsbewegungen federnd zu absorbieren, damit der Sockel 23 keine Schwingungsbewegungen erfährt. Zum anderen dient er dazu, das daraufliegende Aggregat zu tragen.

In Figur 6 sind die Klammern (Bügelpaar 10 und 11) auf der linken Seite des schwingenden Transportsystems in einem zusammengeklappten, den Rand der horizontal angeordneten Leiterplatten umfassend und auf der rechten Seite des Systems (am Entmetallisierungsbehälter 17) entlang gleitend, in einem geöffneten Betriebszustand dargestellt. In beiden Fällen tauchen die unteren Enden des Bügelpaares in die Behandlungslösungen ein. Die zusammengedrückten Bügelenden üben eine starke Klemmwirkung auf den Rand der Leiterplatten aus, so daß somit die Vibrationsschwingungsbewegungen weitgehend verlustfrei auf die Leiterplatten übertragen werden können.

Die in der Figur angedeuteten kreisförmigen Vibrationsschwingungsbewegungen der Leiterplatte werden durch die am Kreisumfang eingezeichneten kleinen Pfeile dargestellt. Die Bewegungen werden um einen Punkt in der Leiterplatte ausgeführt. Die Ebene der Kreisschwingungsbewegungen steht senkrecht auf der Leiterplattenoberfläche. Der vertikale Schwingungsanteil der Bewegung verursacht ein periodisches Durchpumpen der Behandlungslösungen in beiden Richtungen der Lochachse durch die Löcher hindurch.

Durch den horizontalen Schwingungsanteil wird der Stoffaustausch innerhalb der Löcher gesteigert, indem turbulente Schwingungen erzeugt und die Diffusion in der Grenzschicht erhöht werden.

Die beschriebene Anordnung ist ohne weiteres auf Leiterplatten anwendbar, deren Breiten quer zur Tranportrichtung nicht zu groß sind, um nur einseitig an einem Rand erfaßt zu werden. Es muß stets sichergestellt sein, daß die von dem Aggregat ausgehenden Vibrationsschwingungsbewegungen stets gleichmäßg über die gesamte Leiterplattenoberfläche übertragen werden.

In Figur 7 ist ein Querschnitt durch eine Anordnung zur Behandlung sehr breiter Leiterplatten dargestellt. Derartige Leiterplatten können nicht mehr nur einseitig von den Klammern mit den Bügeln 10, 11 erfaßt werden. Aber auch Leiterplatten mit geringer Dicke (Folien) können in dieser Anordnung behandelt werden.

In den genannten Fällen ist es erforderlich, daß geeignete Mittel für den Transport der Leiterplatten sowie für die Stromzuführung zu diesen an zwei sich gegenüberliegenden Seiten der Leiterplatten vorgesehen sind.

In Figur 6 ist der Komplex für die Führung des rechten Randes der Leiterplatte dargestellt, während in Figur 7 schematisch die technische Ausrüstung für die Führung der gegenüberliegenden (linken) Seite der gleichen Platte wiedergegeben ist. In beiden Figuren werden Ausschnitte der Anlage in Querschnittsdarstellung, in Transportrichtung gesehen, gezeigt.

Das die Vibrationsschwingungen erzeugende Aggregat ist quer zur Transportrichtung verschiebbar angeordnet (im Gegensatz zur stationären Anordnung der Einheit in der Figur 6). Dieses Merkmal ist durch den doppelten Pfeil oberhalb der Einheit in der Figur 7 gekennzeichnet.

Die Konstruktionselemente der in den Figuren 6 und 7 dargestellten Aggregateinheiten (Führungsrollen 13 und -schienen 15, endloses Band 14, Anlaufschiene 16, Bürstenvorrichtungen 12 und 18, Bügelpaare 10 und 11, Grundplatte 19 und Unwuchtvibrator 21) sind spiegelbildlich symmetrisch zueinander angeordnet. Durch die seitliche Verfahrbarkeit des Aggregats in der Figur 7 ist es möglich, die Anlage auch für Leiterplatten verschiedener Breiten einzusetzen. Durch dieses Merkmal läßt sich die Anlage mühelos an die sich verändernden unvorhergesehenen Produktionsbedingungen anpassen. Durch das beidseitige Erfassen der Leiterplatten durch die Bügel 10 und 11 wird außerdem die Übertragungsqualität der von den beiden Aggregaten her übermittelten Vibrationsschwingungsbewegungen verbessert.

Vorzugsweise werden die Frequenzen und Amplituden der Schwingungsbewegungen beider beteiligten Unwuchtvibratoren 21 als auch die gleitenden Geschwindigkeiten der beiden beteiligten Transportsysteme synchron aufeinander abgestimmt.

Das Aggregat in Figur 7 ist auf einem schlittenförmigen Fahrgestell aufgesetzt, welches sich im wesentlichen aus einer horizontalen länglichen Bodenplatte 25 aus einigen in einer Reihe darin verankerten lotrechten Tragsäulen 26 und aus einem massiven diese verbindenden Balken 27 zusammensetzt. Der Balken 27 ist das Bindeglied zu den beiden außerhalb des Badbehälters 20 befindlichen auf den Rädern 28 rollenden und seitlich in den Schienen 29 geführten vertikalen Stützgerüsten 30.

An dem verfahrbaren Aggregat ist ferner eine Gegenelektrode angeordnet, um ähnlich der Entmetallisierungskammer 17 in Figur 6 die Enden der auseinandergeklinkten Bügelpaare 10 und 11 auf elektrolytischem Wege reinigen zu können.

Aus Figur 7 ist ferner zu entnehmen, daß die Breite der Leiterplatte die beiden linken unteren Anodenkästen 8 nicht überdeckt.

Für einen einwandfreien Betrieb ist es zwingend notwendig, daß die Anoden 8 und die zu diesen korrespondierenden oberen unlöslichen Anoden 7 von der Stromquelle getrennt werden, sobald diesen keine Leiterplatte gegenüberliegt, um ein gleichmäßiges elektrisches Feld für die Leiterplatten in der Behandlungslösung zu erhalten.

Die Behandlungslösung wird kontinuierlich umgewälzt, um eine möglichst gleichbleibende chemische Zusammensetzung und eine konstante Temperatur in der Umgebung der Leiterplatte zu gewährleisten. Hierzu wird die Badlösung mittels der Pumpe 32 ständig im Kreislauf bewegt. Die strichpunktierten großen und die ausgezogenen kleinen schwarzen Pfeile veranschaulichen die Richtung und den Weg des dabei entstehenden Flüssigkeitskreislaufes. Die Lösung strömt, von der Pumpe 32 her kommend, durch einige in einer Reihe angeordnete Eintrittsstutzen 33 in die Behandlungslösung in der Wanne 20 hinein und nimmt dabei Richtung auf den Raum oberhalb der Leiterplatte. Die Stutzen 33 befinden sich in der Höhe des Badspiegels.

In einer bevorzugten Ausführungsform der Erfindung ist eine Anzahl von Saugkammern 34 vorgesehen, die dicht unterhalb der horizontal angeordneten Oberflächen der Leiterplatten vorgesehen sind. Dadurch wird ein Unterdruck an den unteren Enden der Löcher 2 erzeugt, so daß die zu den oberen Enden der Löcher hinzufließende Behandlungslösung durch diese hindurch nach unten zu strömen gezwungen wird. Die Saugwirkung verstärkt den durch die erfindungsgemäße Vibrationsschwingungsbewegungen erzeugten Stoffaustausch an den Lochwandflächen.

Die chemische und elektrolytische Behandlung der Leiterplatten soll möglichst gleichmäßig und gleichzeitig an allen Orten ihrer Oberflächen und in allen Löchern vor sich gehen. Hierzu sind mehrere unabhängig voneinander wirkende Saugkammern vorgesehen, deren Unterdruck über Magnetventile 35 gesteuert wird.

Die Saugkammern haben vorzugsweise eine prismatische Raumform, deren obere rechteckige Seitenflächen als Öffnungen parallel zu den unmittelbar darübergleitenden Leiterplatten ausgerichtet sind. Jede Saugkammer ist über druckgesteuerte Magnetventile mit einer eigenen Leitung an die Förderpumpe 32 angeschlossen.

Im Falle einer chemischen Oberflächenbehandlung, bei der kein elektrischer Strom benötigt wird, beispielsweise bei der Reinigung von Leiterplatten, werden vorzugsweise die in Figur 8 schematisch dargestellten sich gegenüberliegenden Rollen oder Walzen 37,38 zum Transportieren der Leiterplatten 1,3 verwendet. Die horizontal angeordneten Rollen/Walzen sind senkrecht zur Transportrichtung und zwar in einer Reihe oberhalb und in einer zweiten Reihe unterhalb der Transportbahn gelagert. Die untere Reihe übernimmt als Transportrollen 37 die Aufgabe der Förderung der Leiterplatten von einer Behandlungsstation der Anlage zur nächsten. In der oberen Reihe sind die freilaufenden Andruckrollen 38 vorgesehen. Die Rollen 38 pressen die Leiterplatten spielfrei gegen die untere Reihe der Transportrollen 37 an.

In einer besonders bevorzugten Ausführungsform der Erfindung verlaufen die Vibrationsschwingungsbewegungen in einer horizontalen Ebene, d.h. in der Ebene der Leiterplatten. In diesem Fall werden die Volumenelemente der Behandlungslösung im Loch gegen die Lochwandflächen geschleudert, so daß die Diffusion und die Konvektion in der Behandlungslösung innerhalb des Loches erheblich gesteigert werden. Die kreisförmige Schwingungsbewegung ist in der Figur durch den elliptischen Pfeil angedeutet.

Der waagerechte Pfeil zeigt die Transportrichtung der Leiterplatten an.

Auch in diesem Ausführungsbeispiel ist eine unter der Leiterplatte angeordnete Saugkammer dargestellt, deren breite Öffnung der unteren ebenen Oberfläche in geringem Abstand gegenüberliegt und parallel zu dieser angeordnet ist. Auch in diesem Fall erzeugt der in der Saugkammer gebildete Unterdruck eine Strömung durch die Löcher 2 in Richtung der in der Figur dargestellten Pfeile. Im Gegensatz zu einem Schwallstrahl, der geradlinig entlang des engen Düsenschlitzes nur lokal einen geringen Teil der Platttenoberfläche zu erfassen vermag, können die Saugkammern die Leiterplatte vollständig während der gesamten Zeitdauer des Transportes durch die Behandlungsstation der Anlage erfassen.

In Figur 9 wird eine weitere Anlage in Querschnittsdarstellung wiedergegeben, wobei durch Einsatz von Ultraschallschwingern 36 die Behandlungswirkung des Behandlungsmittels durch die durch die Ultraschallwellen in den Löchern erzeugten Schwingungen gesteigert wird. Die in dieser Darstellung gezeigten weiteren Einzelheiten entsprechen denen in der Figur 6 dargestellten Vorrichtungselementen.

In einer weiteren bevorzugten Ausführungsform wird das Behandlungsmittel mittels Schwall- oder Sprühdüsen an die Leiterplatten herangebracht. Eine Schwalldüse besteht aus einem länglichen geradlinigen Gehäuse, welches senkrecht zur Transportrichtung der horizontal durchlaufenden Leiterplatten sowie parallel zu deren Ebene oder gegen diese geneigt angeordnet ist. Die Düse verfügt über einen oder mehrere Längsschlitze, aus welchen der austretende Schwallstrahl des Behandlungsmittels im wesentlichen senkrecht auf die Leiterplattenoberflächen auftrifft. Die Schwalldüse kann unterhalb oder oberhalb, mehrere Schwalldüsen können auch, zumindest gegeneinander versetzt, auf beiden Seiten der Leiterplatten angeordnet sein. Besonders günstig hat sich eine Kombination von Schwalldüsen und diesen gegenüberliegenden Saugkammern erwiesen.

## Patentansprüche

1. Verfahren zur Behandlung von mit feinsten Löchern versehenen plattenförmigen Werkstücken, insbesondere Leiterplatten, mittels flüssiger oder gasförmiger Behandlungsmittel, bei dem das in einer horizontalen Betriebslage befindliche Werkstück in eine Kombinationsbewegung versetzt wird, welche sich aus

   - einer ersten kontinuierlich und/oder periodisch intermittierend gleitenden Bewegung in einer horizontal verlaufenden Transportbahn und

   - einer zweiten aus heftigen in den löchern instabile Strömungsverhältnisse erzeugenden Vibrationsschwingungen bestehenden Bewegung

   zusammensetzt, wobei beide Bewegungen voneinander unabhängig vorgebbar sind.

2. Verfahren nach Anspruch 1, dadurch gekennzeichnet, daß die Frequenz der Vibrationsschwingungen auf einen Wert größer als 1 Hertz eingestellt wird.

3. Verfahren nach einem der vorstehenden Ansprüche, dadurch gekennzeichnet, daß die Amplitude der Vibrationsschwingungen auf einen Wert kleiner als 10 mm eingestellt wird.

4. Verfahren nach einem der vorstehenden Ansprüche, dadurch gekennzeichnet, daß die Bahn der Vibrationsschwingungsbewegung kreisförmig oder kreisähnlich ist und in einer Ebene verläuft, die im wesentlichen senkrecht zu einer Oberfläche des Werkstückes steht.

5. Verfahren nach einem der Ansprüche 1 - 3, dadurch gekennzeichnet, daß die Bahn der Vibrationsschwingungsbewegung kreisförmig oder kreisähnlich ist und in einer Ebene verläuft, die im wesentlichen parallel zu einer Oberfläche des Werkstückes steht.

6. Verfahren nach einem der Ansprüche 4 oder 5, dadurch gekennzeichnet, daß die Drehrichtung der Vibrationsschwingungsbewegung periodisch wechselt.

7. Verfahren nach einem der vorstehenden Ansprüche, dadurch gekennzeichnet, daß die Werkstücke mittels Ultraschallwellen, die im wesentlichen senkrecht auf die Oberflächen des Werkstückes auftreffen, behandelt werden.

8. Verfahren nach einem der vorstehenden Ansprüche, dadurch gekennzeichnet, daß das Werkstück vollständig in das Behandlungsmittel eingetaucht wird.

9. Verfahren nach einem der vorstehenden Ansprüche, dadurch gekennzeichnet, daß im wesentlichen kontinuierliche Ströme oder Strahlen eines flüssigen Behandlungsmittels gegen die Oberfläche des Werkstückes gerichtet und durch die Löcher im Werkstück geleitet werden.

10. Verfahren nach einem der vorstehenden Ansprüche, dadurch gekennzeichnet, daß das Behandlungsmittel durch die Löcher des Werkstückes durch Erzeugen eines Unterdruckes an einer der Werkstückoberflächen hindurchgesaugt wird.

11. Verfahren nach einem der vorstehenden Ansprüche, dadurch gekennzeichnet, daß als Behandlungsmittel erwärmte Luft zum Trocknen der Lochwände und der Oberflächen des Werkstückes verwendet wird.

12. Vorrichtung zur Behandlung von mit feinsten Löchern versehenen plattenförmigen Werkstücken, insbesondere Leiterplatten, mittels flüssiger oder gasförmiger Behandlungsmittel, umfassend Mittel (10,11,37,38) zum Erfassen der Werkstücke (1,3) in horizontaler Betriebslage und zum kontinuierlichen und/oder periodisch intermittierend gleitenden Bewegen in einer horizontal verlaufenden Transportbahn, und Mittel (21) zum Einleiten heftig pulsierender Vibrationsschwingungsbewegungen in die Werkstücke, in der Weise, daß in den Löchern instabile Strömungsverhältnisse erzeugt werden, wobei beide Bewegungen selbständig und voneinander unabhängig sind, sowie Mittel zum In-Kontakt-Bringen der Werkstücke mit dem Behandlungsmittel.

13. Vorrichtung nach Anspruch 12, gekennzeichnet durch einen Unwuchtvibrator (21) zur Erzeugung kreisförmiger oder kreisähnlicher Vibrationsschwingungsbewegungen der Werkstücke (1,3).

14. Vorrichtung nach einem der Ansprüche 12 oder 13, gekennzeichnet durch Ultraschallschwinger (36) zur Erzeugung von im wesentlichen senkrecht auf die Oberflächen der Werkstücke (1,3) auftreffenden Ultraschallwellen im Behandlungsmittel.

15. Vorrichtung nach einem der Ansprüche 12 bis 14, gekennzeichnet durch Mittel zum Erzeugen eines auf die Werkstückoberfläche gerichteten kontinuierlichen Stromes oder eines Strahles eines flüssigen Behandlungsmittels.

16. Vorrichtung nach einem der Ansprüche 12 bis 15, gekennzeichnet durch Mittel zum Hindurchsaugen des Behandlungsmittels durch die Löcher (2) im Werkstück (1,3), umfassend eine oder mehrere Saugkammern (34) mit vorzugsweise rechteckigen der einen Oberfläche des Werkstückes in geringem Abstand gegenüberliegenden Öffnungen.

**Claims**

1. Method of treating plate-like workpieces which are provided with very fine holes, more especially printed circuit boards, by means of liquid or gaseous treatment agents, wherein the workpiece situated in a horizontal operational position is set into a combination movement, which comprises

   - a first continuously and/or periodically intermittently sliding movement in a horizontally extending path of conveyance, and

   - a second movement, which comprises strong vibration oscillations producing unstable flow conditions in the holes,

   both movements being variable independently of each other.

2. Method according to claim 1, characterised in that the frequency of the vibration oscillations is set to a value greater than 1 Hertz.

3. Method according to one of the preceding claims, characterised in that the amplitude of the vibration oscillations is set to a value smaller than 10 mm.

4. Method according to one of the preceding claims, characterised in that the path of the vibration oscillation movement is circular or circular-like and extends in a plane which lies substantially perpendicular to a surface of the workpiece.

5. Method according to one of claims 1 - 3, characterised in that the path of the vibration oscillation movement is circular or circular-like and extends in a plane which lies substantially parallel to a surface of the workpiece.

6. Method according to one of claims 4 or 5, characterised in that the direction of rotation of the vibration oscillation movement changes periodically.

7. Method according to one of the preceding claims, characterised in that the workpieces are treated by means of ultrasonic waves, which impinge upon the surfaces of the workpiece substantially perpendicularly.

8. Method according to one of the preceding claims, characterised in that the workpiece is completely immersed in the treatment agent.

9. Method according to one of the preceding claims, characterised in that substantially continuous currents or jets of a liquid treatment agent are directed towards the surface of the workpiece and guided through the holes in the workpiece.

10. Method according to one of the preceding claims, characterised in that the treatment agent is sucked through the holes of the workpiece by producing a reduced pressure region at one of the workpiece surfaces.

11. Method according to one of the preceding claims, characterised in that heated air is used as the treatment agent for the drying of the hole walls and the surfaces of the workpiece.

12. Apparatus for treating plate-like workpieces which are provided with very fine holes, more especially printed circuit boards, by means of liquid or gaseous treatment agents, including means (10,11,37,38) for gripping the workpieces (1,3) in a horizontal operational position and for the continuous and/or periodically intermittently sliding movement of said workpieces in a horizontally extending path of conveyance, and means (21) for introducing strongly pulsating vibration oscillation movements into the workpieces in such a manner that unstable flow conditions are produced in the holes, both movements being self-contained and independent of each other, as well as means for bringing the workpieces into contact with the treatment agent.

13. Apparatus according to claim 12, characterised by an unbalanced mass vibration generator (21) for producing circular or circular-like vibration oscillation movements of the workpieces (1,3).

14. Apparatus according to one of claims 12 or 13, characterised by ultrasonic transmitters (36) for producing ultrasonic waves in the treatment agent, which waves impinge upon the surfaces of the workpieces (1,3) substantially perpendicularly.

15. Apparatus according to one of claims 12 to 14, characterised by means for producing a continuous current directed onto the workpiece surface or a jet of a liquid treatment agent.

16. Apparatus according to one of claims 12 to 15, characterised by means for sucking the treatment agent through the holes (2) in the workpiece (1,3), including one or more suction chambers (34) provided with preferably rectangular apertures which lie opposite one surface of the workpiece at a slight spacing therefrom.

**Revendications**

1. Procédé pour traiter des pièces en forme de plaques pourvues de trous très fins, en particulier des cartes imprimées, au moyen d'agents de traitement liquides ou gazeux, avec lequel la pièce se trouvant dans une position de service horizontale est soumise à un mouvement combiné, qui comprend

   - un premier mouvement de glissement continu et/ou à intermittence périodique dans une glissière horizontale et

   - un deuxième mouvement comprenant des oscillations vibratoires violentes générant des conditions d'écoulement instables dans les trous,

   les deux mouvements pouvant être prédéfinis indépendamment l'un de l'autre.

2. Procédé selon la revendication 1 caractérisé en ce que la fréquence des oscillations vibratoires est réglée sur une valeur supérieure à 1 hertz.

3. Procédé selon l'une quelconque des revendications précédentes, caractérisé en ce que l'amplitude des oscillations vibratoires est réglée sur une valeur inférieure à 10 mm.

4. Procédé selon l'une quelconque des revendications susmentionnées, caractérisé en ce que la trajectoire des mouvements d'oscillation vibratoire est de forme circulaire ou quasi-circulaire et se situe dans un plan qui est sensiblement perpendiculaire à une surface de la pièce.

5. Procédé selon l'une quelconque des revendications 1 à 3, caractérisé en ce que la trajectoire du mouvement d'oscillation vibratoire est circulaire ou quasi-circulaire et se situe dans un plan qui est sensiblement parallèle à une surface de la pièce.

6. Procédé selon l'une quelconque des revendications 4 ou 5, caractérisé en ce que le sens de rotation du mouvement d'oscillation vibratoire change de façon périodique.

7. Procédé selon l'une quelconque des revendications précédentes, caractérisé en ce que les pièces sont traitées au moyen d'ondes ultrasonores, qui arrivent sensiblement perpendiculairement aux surfaces de la pièce.

8. Procédé selon l'une quelconque des revendications précédentes, caractérisé en ce que la pièce est immergée complètement dans l'agent de traitement.

9. Procédé selon l'une quelconque des revendications précédentes, caractérisé en ce que des courants sensiblement continus ou des jets d'un agent de traitement liquide sont dirigés vers la surface de la pièce et sont guidés par les trous dans la pièce.

10. Procédé selon l'une quelconque des revendications précédentes, caractérisé en ce que l'agent de traitement est aspiré par les trous de la pièce en générant une dépression sur l'une des surfaces de la pièce.

11. Procédé selon l'une quelconque des revendications précédentes, caractérisé en ce qu'on utilise de l'air réchauffé comme agent de traitement pour sécher les parois perforées et les surfaces de la pièce.

12. Dispositif pour traiter des pièces en forme de plaques pourvues de trous fins, en particulier des cartes imprimées, au moyen d'agents de traitement liquides ou gazeux, comprenant des moyens (10, 11, 37, 38) pour saisir les pièces (1, 3) dans une position de service horizontale et pour le déplacement de glissement continu et/ou par intermittence périodique dans une glissière de transport disposée horizontalement, et des moyens (21) pour amorcer des mouvements d'oscillation vibratoire à pulsation violente, en ce sens que des conditions d'écoulement instables sont générées dans les trous, les deux mouvements étant autonomes et indépendants l'un de l'autre, et des moyens pour mettre en contact les pièces avec l'agent de traitement.

13. Dispositif selon la revendication 12, caractérisé par un générateur de vibrations à balourd (21) pour générer des mouvements d'oscillation vibratoire, circulaires ou quasi-circulaires, des pièces (1, 3).

14. Dispositif selon l'une quelconque des revendications 12 ou 13, caractérisé par un émetteur d'ultrasons (36) pour générer des ondes ultrasonores arrivant sensiblement perpendiculairement sur les surfaces des pièces (1, 3) dans l'agent de traitement.

15. Dispositif selon l'une quelconque des revendications 12 à 14, caractérisé par des moyens pour générer un courant continu dirigé sur la surface de la pièce ou un jet d'un agent de traitement liquide.

16. Dispositif selon l'une quelconque des revendications 12 à 15, caractérisé par des moyens pour aspirer l'agent de traitement par les trous (2) disposés dans la pièce (1, 3), comprenant une ou plusieurs chambres d'aspiration (34) avec des ouvertures de préférence rectangulaires et situées à faible distance en regard d'une surface de la pièce.

EP 0 801 883 B1

Fig. 1

Fig.2

Fig. 3a

Fig. 3b

Fig. 4

Fig.5

Fig. 6

Fig. 7

EP 0 801 883 B1

Fig. 8

Fig.9